# FASCICULE DE BREVET EUROPEEN

(11) **EP 1 168 906 B1**
(45) Date de publication et mention de la délivrance du brevet: **14.09.2005**
(21) Numéro de dépôt: 01401458.3
(22) Date de dépôt: 06.06.2001
(51) Int. Cl.: H05K 7/20, H01L 23/473

(54) **Module de puissance à composants électroniques de puissance et procédé de fabrication d'un tel module**
Elektronisches Leistungsmodul mit elektronischen Hochleistungsbauteilen und zugehöriges Herstellungsverfahren
Power module with electronic power components and production method thereof

(30) Priorité: 23.06.2000 FR 0008121
(43) Date de publication de la demande: 02.01.2002
(73) Titulaire: Alstom, 92300 Levallois-Perret (FR)
(72) Inventeur: Petitbon, Alain, 64000 Pau (FR)
(74) Mandataire: Blot, Philippe Robert Emile

(56) Documents cités:
- EP-A- 0 471 552
- EP-A- 0 798 954
- DE-A- 3 147 789
- DE-A- 19 653 956

## Description

L'invention se rapporte à un module de puissance à composant électronique de puissance et à un procédé de fabrication d'un tel module puissance. L'invention se rapporte plus particulièrement à un module de puissance comportant une semelle constituant un échangeur de chaleur chargé d'évacuer les dissipations de puissance par effet joule des composants de puissance.

La présente invention trouve application pour la fabrication d'onduleurs dans le domaine des moyennes puissances notamment pour les applications routières de type véhicules électriques pour lesquels les puissances sont de l'ordre de 30 à 200 kW et les tensions aux bornes des modules de puissance sont de l'ordre de 500 V à 2000 V.

Un module de puissance selon le préambule de la revendication 1 est connu du document EP-A-0 798 954.

Il est connu de réaliser un module de puissance constitué de composants de puissance brasés sur une peau en aluminium disposée sur une face d'un substrat céramique en nitrure d'aluminium AlN, l'autre face du substrat céramique AlN étant recouverte d'une peau en aluminium et accolée à une semelle en composite AISiC constituant un échangeur de chaleur. Dans un tel module de puissance, le substrat en AlN assure l'isolation électrique des composants à haut potentiel par rapport à la semelle en AISiC mise à la masse, cependant un tel substrat en nitrure d'aluminium AlN est relativement coûteux et n'est disponible dans le commerce qu'avec une épaisseur minimale de 0.635 mm alors que pour certaine application, et notamment pour tenir les tensions dans les véhicules électriques, une épaisseur de 0.1 mm serait suffisante pour assurer l'isolation. Tous ces inconvénients conduisent à des modules de puissance trop onéreux pour les applications automobiles.

Le but de la présente invention est donc de proposer un module de puissance qui procure une bonne dissipation thermique de la puissance dégagée par les composants de puissance et qui soit simple et économique à fabriquer.

L'invention a pour objet un module de puissance à composants électroniques de puissance comportant une semelle constituant un échangeur de chaleur chargé d'évacuer les dissipations de puissance par effet joule des composants de puissance, caractérisé en ce que la semelle comporte une face munie d'une peau en alliage d'aluminium, cette dernière étant recouverte d'une couche isolante d'oxyde d'aluminium obtenue par anodisation de la peau en alliage d'aluminium, la couche isolante d'oxyde d'aluminium constituant un substrat sur lequel des pistes métallisées sont réalisées afin de recevoir les composants électroniques, l'autre face de la semelle étant en contact avec un fluide de refroidissement.

Selon des modes particuliers de réalisation, le module de puissance peut comprendre l'une ou plusieurs des caractéristiques suivantes prises isolément ou selon toutes les combinaisons techniquement possibles :
- la semelle est en composite AlSiC ;
- la semelle est en aluminium ;
- la semelle au contact du fluide de refroidissement comporte des picots ou des microcanaux plongeant à l'intérieur du fluide, les picots ou microcanaux étant réalisés directement dans la semelle ou dans une peau d'aluminium rapportée sur la semelle ;
- les pistes métallisées sont réalisées par dépôt de cuivre ;
- les composants de puissance sont brasés sur les pistes de cuivre ;
- les composants de puissance sont des composants IGBT ;
- trois groupes de composants IGBT sont brasés sur un même substrat, les pistes de chaque groupe d'IGBT étant séparées les unes des autres de telle sorte que deux substrats constituent un onduleur triphasé.

L'invention concerne également un procédé de fabrication du module de puissance précédemment décrit, caractérisé en ce que la couche d'oxyde d'aluminium est obtenue par anodisation de la peau en alliage d'aluminium dans de l'acide sulfurique au voisinage de 0°C.

Selon des modes particuliers de réalisation, le procédé de fabrication peut comprendre l'une ou plusieurs des caractéristiques suivantes prises isolément ou selon toutes les combinaisons techniquement possibles :
- la couche d'oxyde obtenue est immergée dans de l'eau chaude pour former de l'hydroxyde d'aluminium en surface afin de réduire la porosité de la couche d'oxyde d'aluminium ;
- la peau en alliage d'aluminium recouvrant la semelle est obtenue directement lors du moulage de la semelle par une forme adaptée du moule ;
- la couche d'oxyde d'aluminium est métallisée par dépôt électrolytique de cuivre sur des pistes préalablement activées par traitement au laser Ultraviolet, les pistes de cuivre étant ensuite nickelées par procédé électroless.

On comprendra mieux les buts, aspects et avantages de la présente invention, d'après la description donnée ci-après de plusieurs modes de réalisation de l'invention, présentés à titre d'exemple non limitatif, en se référant aux dessins annexés, dans lesquels :
- la figure 1 est une vue schématique en coupe d'un module de puissance, selon un premier mode de réalisation de l'invention, monté sur un collecteur d'eau ;
- la figure 2 est une vue de dessous du module de puissance de la figure 1 ;
- la figure 3 est une vue de dessus du module de puissance de la figure 1 ;
- la figure 4 est une vue schématique en coupe d'un module de puissance selon un second mode de réalisation de l'invention.

Pour faciliter la lecture du dessin, seuls les éléments nécessaires à la compréhension de l'invention ont été représentés.

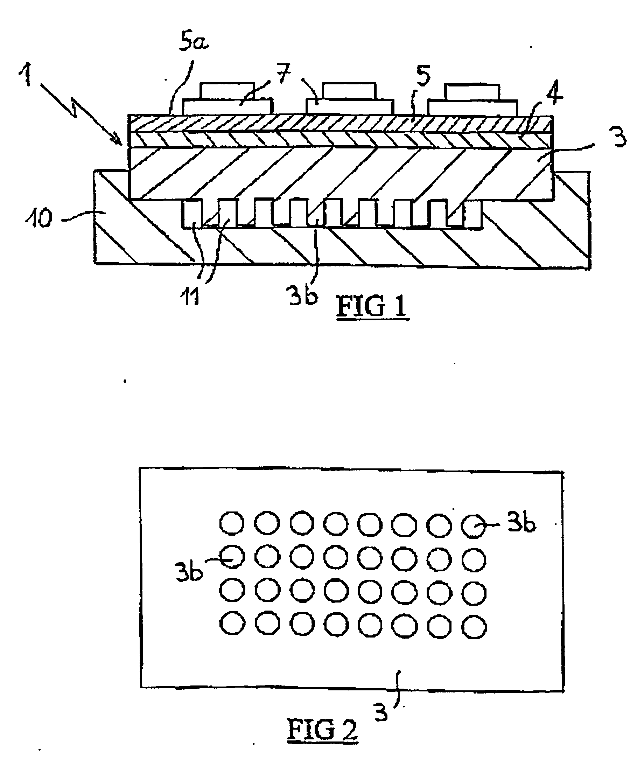

La figure 1 représente un module de puissance 1 associé à un collecteur d'eau 10 en plastique moulé comportant une veine 11 dans laquelle circule de l'eau de refroidissement.

Le module de puissance 1 comporte une semelle 3 en composite AISiC (Aluminium Carbure Silicium) fixée de manière étanche sur le collecteur d'eau 10 et comportant une face inférieure munie de picots 3b, représentés sur la figure 2, plongeant dans la veine de fluide 11 du collecteur 10 et favorisant l'échange thermique entre la semelle 3 en AISiC et le fluide de refroidissement.

La face supérieure de la semelle 3 en AISiC comporte une peau 4 en alliage d'aluminium qui est recouverte d'une couche 5 d'oxyde d'aluminium d'une épaisseur de 50 µm à 100 µm assurant une isolation électrique permettant de supporter des tensions différentielles entre les deux faces de la couche d'oxyde l'aluminium de plus de 1000V sans claquage.

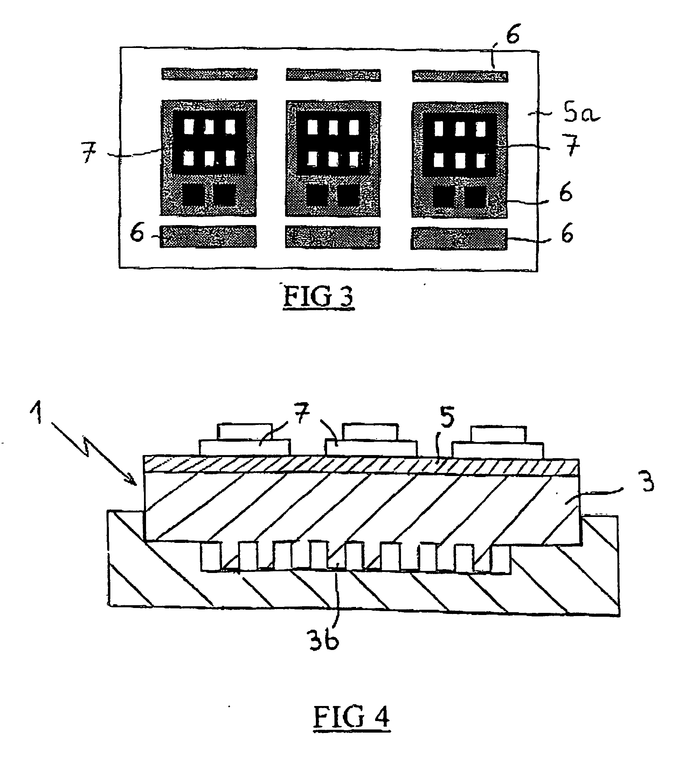

La semelle 3, munie de sa couche 5 d'oxyde d'aluminium, constitue un substrat sur lequel des pistes 6 sont métallisées suivant un tracé prédéterminé pour servir de collecteur de courant à trois groupes de composants IGBT 7 brasés sur lesdites pistes métallisées 6. Avantageusement, ainsi que cela est représenté sur la figure 3, les pistes 6 d'alimentation de chacun des trois IGBT sont séparées les unes des autres afin de permettre la réalisation d'un demi-onduleur triphasé sur un seul substrat.

Le procédé de fabrication d'un tel module de puissance va maintenant être décrit.

La semelle 3 en AlSiC est réalisée de manière classique par injection d'aluminium dans un moule sur des fibres en carbure de silicium, la forme du moule étant adaptée pour que la peau 4 en aluminium se forme à la surface supérieure de la semelle 3 en AlSiC. Dans une variante de réalisation non représentée, la face inférieure de la semelle 3 au contact du fluide de refroidissement pourra également comporter une peau en aluminium, présentant des picots ou des microcanaux, réalisée directement lors de l'opération de moulage de la semelle 3 par une forme adaptée du moule.

La peau 4 en alliage d'aluminium de la semelle 3 est ensuite recouverte d'une couche 5 d'oxyde d'aluminium par anodisation de la peau 4 dans de l'acide sulfurique. A température ambiante, cette anodisation permet d'obtenir une épaisseur d'oxyde d'aluminium de l'ordre de 20 µm, l'épaisseur d'oxyde d'aluminium étant limitée par la dissolution de l'oxyde formé dans l'acide. De manière préférentielle, l'anodisation sera effectuée à une température de 0°C afin d'obtenir une épaisseur d'oxyde d'aluminium plus importante, jusqu'à 100 µm, et le dépôt d'oxyde ainsi obtenu sera immergé dans de l'eau chaude afin de diminuer la porosité de la couche 5 d'oxyde d'aluminium par formation d'hydroxyde d'aluminium.

Bien entendu, l'épaisseur de la couche 5 d'oxyde d'aluminium ainsi formée dépend également de la teneur en aluminium de l'alliage utilisé pour constituer la peau 4, car plus l'alliage utilisé est riche en aluminium plus l'épaisseur de la couche 5 d'oxyde d'aluminium créée par anodisation est importante.

La face supérieure Sa de la couche 5 d'oxyde l'aluminium est ensuite métallisée par dépôt électrolytique de cuivre sur des pistes 6 préalablement activées par traitement laser UV puis nickelées par procédé électroless, l'adhérence des couches métalliques étant renforcée par un recuit à 400-500°C tolérable par l'aluminium et ses alliages. Un procédé semblable de métallisation est décrit dans la demande de brevet FR-A1-2 681 078. Les composants IGBT 7 sont ensuite brasés de manière classique sur les pistes 6 de cuivre.

Un tel procédé de fabrication permet d'avoir une très bonne conduction thermique entre la couche d'oxyde d'aluminium 5 et la peau 4 grâce à l'interpénétration de la couche 5 avec la peau 4. Par ailleurs, la peau 4, en étant obtenue directement lors du moulage de la semelle 3 en AlSiC, forme un seul corps avec la semelle 3, sans interface de séparation, ce qui assure un excellente conductivité thermique entre la peau 4 et la semelle 3.

En conséquence, un tel procédé de fabrication permet de réaliser un module de puissance peu coûteux assurant un bon refroidissement des composants de puissance du fait de la très bonne conductivité thermique entre les différentes couches du module de puissance. Par ailleurs, le substrat ainsi obtenu présente très peu de différences de dilatation thermique entre les couches et possède donc une très bonne fiabilité en présentant très peu de risque de délaminage des brasures après un nombre important de cycle thermique. Un tel procédé de fabrication permet également d'adapter l'épaisseur la couche d'oxyde d'aluminium constituant l'isolant électrique au besoin du module de puissance afin de minimiser l'épaisseur de couche d'oxyde et réduire ainsi sa résistance thermique.

La figure 4 présente une second mode de réalisation du module de puissance selon l'invention se différentiant du premier mode de réalisation précédemment décrit par le fait que la semelle 3 est entièrement réalisée en alliage d'aluminium. Conformément à cette figure 4, le module de puissance 1 comporte une semelle 3 en aluminium présentant une face inférieure, au contact du fluide de refroidissement, munie de picots 3b obtenus directement lors du moulage de la semelle 3 en aluminium. La face supérieure de la semelle 3 est recouverte d'une couche 5 d'oxyde d'aluminium obtenue par anodisation selon un procédé similaire à celui décrit pour le premier mode de réalisation de l'invention. Des pistes sont métallisées sur la couche 5 d'oxyde d'aluminium, selon un procédé similaire à celui décrit pour le premier mode de réalisation, afin de servir de collecteur de courant à trois groupes de composants IGBT 7, ces derniers étant brasés sur les pistes au moyen d'une brasure tendre du type étain, plomb ou argent capable d'accommoder les dilatations différentielles.

Une telle variante de réalisation de l'invention permet de réduire encore le coût de fabrication du module de puissance en supprimant l'utilisation de composite en AlSiC et en le remplaçant par de l'alliage d'aluminium. Toutefois, le module de puissance ainsi obtenu présentera une moins bonne fiabilité en cycle thermique du fait de la plus forte dilatation différentielle entre les composants de puissance et la semelle en aluminium et nécessitera donc l'utilisation d'une brasure tendre pour braser les composants.

## Revendications

1. Module de puissance (1) à composants électroniques de puissance (7) comportant une semelle (3) constituant un échangeur de chaleur chargé d'évacuer les dissipations de puissance par effet joule desdits composants de puissance, **caractérisé en ce que** ladite semelle (3) comporte une face munie d'une peau (4) en alliage d'aluminium, ladite peau (4) étant recouverte d'une couche isolante (5) d'oxyde d'aluminium obtenue par anodisation de ladite peau (4), ladite couche isolante (5) constituant un substrat sur lequel des pistes métallisées (6) sont réalisées afin de recevoir lesdits composants électroniques (7), l'autre face de ladite semelle (3) étant en contact avec un fluide de refroidissement.

2. Module de puissance selon la revendication 1, **caractérisé en ce que** ladite semelle (3) est en composite AlSiC.

3. Module de puissance selon la revendication 1, **caractérisé en ce que** ladite semelle (3) est en aluminium.

4. Module de puissance selon l'une quelconque des revendication 1 à 3, **caractérisé en ce que** la face de la semelle (3) au contact du fluide de refroidissement comporte des picots (3b) ou des microcanaux plongeant à l'intérieur dudit fluide, lesdits picots (3b) ou microcanaux étant réalisés directement dans la semelle (3) ou dans une peau d'aluminium rapportée sur ladite semelle (3).

5. Module de puissance selon l'une quelconques des revendications 1 à 4, **caractérisé en ce que** les pistes métallisées (6) sont réalisées par dépôt de cuivre.

6. Module de puissance selon la revendication 5, **caractérisé en ce que** lesdits composants de puissance (7) sont brasés sur lesdites pistes (6) de cuivre.

7. Module de puissance selon l'une quelconque des revendications 1 à 6, **caractérisé en ce que** lesdits composants de puissance (7) sont des composants IGBT.

8. Module de puissance selon la revendication 7, **caractérisé en ce que** trois groupes de composants IGBT (7) sont brasés sur un même substrat, les pistes (6) de chaque groupe d'IGBT (7) étant séparées les unes des autres de telle sorte que deux substrats constituent un onduleur triphasé.

9. Procédé de fabrication d'un module de puissance (1) selon l'une quelconque des revendications 1 à 8, **caractérisé en ce que** ladite couche (5) d'oxyde d'aluminium est obtenue par anodisation de la peau (4) en alliage d'aluminium dans de l'acide sulfurique au voisinage de 0°C.

10. Procédé de fabrication selon la revendication 9, **caractérisé en ce que** la couche (5) ainsi obtenue est immergée dans de l'eau chaude pour former de l'hydroxyde d'aluminium en surface afin de réduire la porosité de ladite couche (5) d'oxyde d'aluminium.

11. Procédé de fabrication selon l'une quelconques des revendications 9 à 10, **caractérisé en ce que** la peau (4) en alliage d'aluminium recouvrant la semelle (3) est obtenue directement lors du moulage de ladite semelle (3) par une forme adaptée du moule.

12. Procédé de fabrication selon l'une quelconque des revendications 9 à 11, **caractérisé en ce que** la couche (5) d'oxyde d'aluminium est métallisée par dépôt électrolytique de cuivre sur des pistes (6) préalablement activées par traitement au laser Ultraviolet, lesdites pistes de cuivre (6) étant ensuite nickelées par procédé électroless.

## Patentansprüche

1. Leistungsmodul (1) mit elektronischen Hochleistungsbauteilen (7), das eine Grundplatte (3) umfasst, die einen Last-Wärmetauscher zum Abführen der Leistungsverluste durch den Joule-Effekt der Hochleistungsbauteile bildet, **dadurch gekennzeichnet, dass** die Grundplatte (3) eine Seite aufweist, die mit einer Schicht (4) aus einer Aluminiumlegierung versehen ist, wobei die Schicht (4) mit einer isolierenden Schicht (5) aus Aluminiumoxid bedeckt ist, die durch anodische Oxidation der Schicht (4) erhalten wurde, wobei die isolierenden Schicht (5) ein Substrat bildet, auf dem metallisierte Bahnen (6) ausgeführt sind, um die elektronischen Bauteile (7) aufzunehmen, wobei die andere Seite der Grundplatte (3) mit einem Kühlfluid in Kontakt steht.

2. Leistungsmodul nach Anspruch 1, **dadurch gekennzeichnet, dass** die Grundplatte (3) aus einem AlSiC-Verbundstoff besteht.

3. Leistungsmodul nach Anspruch 1, **dadurch gekennzeichnet, dass** die Grundplatte (3) aus Aluminium besteht.

4. Leistungsmodul nach einem der Ansprüche 1 bis 3, **dadurch gekennzeichnet, dass** die Seite der Grundplatte (3) im Kontakt mit dem Kühlfluid Stifte (3b) oder Mikrokanäle aufweist, die in das Innere des Fluids eintaucht, wobei die Stifte (3b) oder Mikrokanäle direkt in der Grundplatte (3) oder in einer an die Grundplatte (3) angesetzten Aluminiumschicht ausgeführt sind.

5. Leistungsmodul nach einem der Ansprüche 1 bis 4, **dadurch gekennzeichnet, dass** die metallisierten Bahnen (6) durch Abscheidung von Kupfer ausgeführt sind.

6. Leistungsmodul nach Anspruch 5, **dadurch gekennzeichnet, dass** die Hochleistungsbauteile (7) auf die Kupferbahnen (6) gelötet sind.

7. Leistungsmodul nach einem der Ansprüche 1 bis 6, **dadurch gekennzeichnet, dass** die Hochleistungsbauteile (7) IGBT-Bauteile sind.

8. Leistungsmodul nach Anspruch 7, **dadurch gekennzeichnet, dass** drei Gruppen von IGBT-Bauteilen (7) auf dasselbe Substrat gelötet sind, wobei die Bahnen (6) jeder IGBT-Gruppe (7) voneinander getrennt sind, so dass zwei Substrate einen dreiphasigen Wechselrichter bilden.

9. Verfahren zur Herstellung eines Leistungsmoduls (1) nach einem der Ansprüche 1 bis 8, **dadurch gekennzeichnet, dass** die Aluminiumoxidschicht (5) durch anodische Oxidation der Schicht (4) aus einer Aluminiumlegierung in Schwefelsäure in der Nähe von 0°C erhalten wird.

10. Herstellungsverfahren nach Anspruch 9, **dadurch gekennzeichnet, dass** die so erhaltene Schicht (5) in heißes Wasser getaucht wird, um Aluminiumhydroxid an der Oberfläche auszubilden, um die Porosität der Aluminiumoxidschicht (5) zu verringern.

11. Herstellungsverfahren nach einem der Ansprüche 9 bis 10, **dadurch gekennzeichnet, dass** die Schicht (4) aus einer Aluminiumlegierung, die die Grundplatte (3) bedeckt, direkt bei der Formung der Grundplatte (3) durch eine angepasste Gestalt der Form erhalten wird.

12. Verfahren nach einem der Ansprüche 9 bis 11, **dadurch gekennzeichnet, dass** die Aluminiumoxidschicht (5) durch elektrolytische Abscheidung von Kupfer auf vorher durch Ultraviolettlaser-Behandlung aktivierten Bahnen metallisiert wird, wobei die Kupferbahnen (6) anschließend durch einen stromlosen Vorgang vernickelt werden.

## Claims

1. A power module (1) having electronic power components (7), the module comprising a soleplate (3) constituting a heat exchanger for dumping the power dissipated by the Joule effect in said power components, the module being **characterized in that** said soleplate (3) has a face that is provided with a skin (4) of aluminum alloy, said skin (4) being covered in an insulating layer (5) of aluminum oxide obtained by anodizing said skin (4), said insulating layer (5) constituting a substrate on which metallized tracks (6) are made in order to receive said electronic components (7), the other face of said soleplate (3) being in contact with a cooling fluid.

2. A power module according to claim 1, **characterized in that** said soleplate (3) is made of AlSiC composite.

3. A power module according to claim 1, **characterized in that** said soleplate (3) is made of aluminum.

4. A power module according to any one of claims 1 to 3, **characterized in that** the face of the soleplate (3) which comes into contact with the cooling fluid has studs (3b) or microchannels that dip into said fluid, said studs (3b) or microchannels being made directly on the soleplate (3) or on an aluminum skin applied to said soleplate (3).

5. A power module according to any one of claims 1 to 4, **characterized in that** the metallized tracks (6) are made by depositing copper.

6. A power module according to claim 5, **characterized in that** said power components (7) are brazed to said copper tracks (6).

7. A power module according to any one of claims 1 to 6, **characterized in that** said power components (7) are IGBT components.

8. A power module according to claim 7, **characterized in that** three groups of IGBT components (7) are brazed onto a common substrate, the tracks (6) of each group of IGBT components (7) being separated from one another so that two substrates can constitute a three-phase inverter.

9. A method of manufacturing a power module (1) according to any one of claims 1 to 8, the method being **characterized in that** said aluminum oxide layer (5) is obtained by anodizing the aluminum alloy skin (4) in sulfuric acid at about 0°C.

10. A method of manufacture according to claim 9, **characterized in that** the layer (5) obtained in this way is immersed in hot water to form aluminum hydroxide on its surface so as to reduce the porosity of said aluminum oxide layer (5).

11. A method of manufacture according to claim 9 or 10, **characterized in that** the aluminum alloy skin (4) covering the soleplate (3) is obtained directly when molding said soleplate (3) by means of a mold of appropriate shape.

12. A method of manufacture according to any one of claims 9 to 11, **characterized in that** the aluminum oxide layer (5) is metallized by electrolytically depositing copper on tracks (6) that have previously been activated by ultraviolet laser treatment, said copper tracks (6) subsequently being nickel-plated by the electroless process.
